# EUROPEAN PATENT SPECIFICATION

(11) **EP 0 398 247 B1**
(45) Date of publication and mention of the grant of the patent: **19.11.1997**
(21) Application number: 90109125.6
(22) Date of filing: 15.05.1990
(51) Int. Cl.: H01L 27/06, H01L 21/82

(54) **Semidonductor device and method of manufacturing the same**
Halbleitervorrichtung und Verfahren zu seiner Herstellung
Dispositif semi-conducteur et son procédé de fabrication

(30) Priority: 17.05.1989 JP 121569/89
(43) Date of publication of application: 22.11.1990
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi, Kanagawa-ken (JP)
(72) Inventor: Momose, Hiroshi, c/o Intellectual Property Div., Minato-ku, Tokyo 105 (JP); Unno, Yukari, c/o Intellectual Property Div., Minato-ku, Tokyo 105 (JP)
(74) Representative: Lehn, Werner, Dipl.-Ing.

(56) References cited:
- EP-A- 0 219 641
- GB-A- 1 237 712
- GB-A- 1 280 022
- US-A- 4 267 557
- US-A- 4 388 634
- PATENT ABSTRACTS OF JAPAN vol. 13, no. 46 (E-711)(3394) 2 February 1989 & JP-A-63 240 058
- IBM TECHNICAL DISCLOSURE BULLETIN. vol. 13, no. 7, December 1970, NEW YORK, US page 1981; E.E. DAVIDSON ET AL.: 'Symmetrical transistor structure.'

## Description

This invention relates to a semiconductor device having a bipolar transistor and a method for manufacturing the same, and more particularly to a Bi-CMOS device and a method of manufacturing the same.

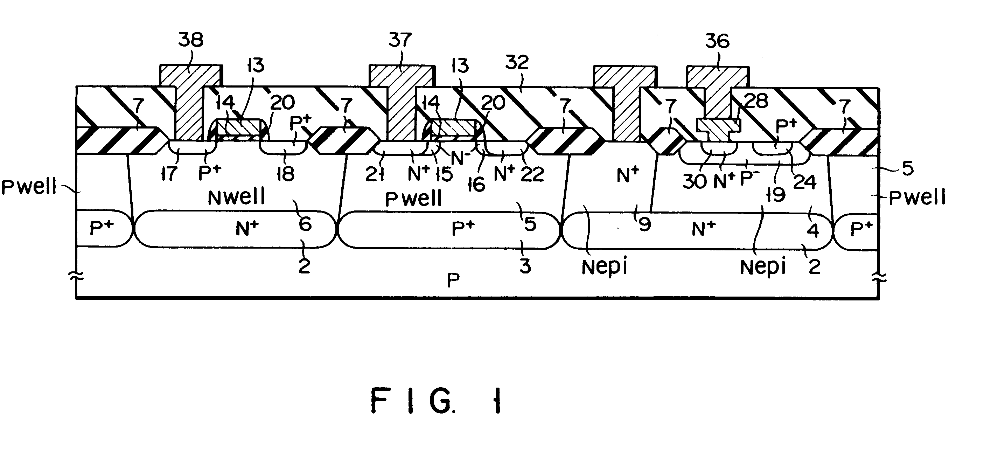

Fig. 1 is a cross sectional view showing the construction of a Bi-CMOS device having a bipolar transistor and CMOS transistors disposed therein disclosed in Japanese Patent Application No. 63-170683 filed by the Applicant of this invention. In Fig. 1, reference numeral 1 denotes a P-type substrate, 2 an N⁺-buried layer, 3 a P⁺-buried layer, 4 an N-type epitaxial layer, 5 a P-well region, 6 an N-well region, 7 a field oxide film, 9 an N⁺-diffused layer, 13 a polysilicon layer, 14 a gate oxide film, 15 an nMOS source region having a low impurity concentration, 16 an nMOS drain region having a low impurity concentration, 17 a pMOS source region, 18 a pMOS drain region, 19 an external base region, 20 a CVD-SiO₂ film, 21 an nMOS source region having a high impurity concentration, 22 an nMOS drain region having a high impurity concentration, 24 a base region, 28 a polysilicon layer serving as an emitter electrode, 30 an emitter region, 32 an interlayer film, and 36, 37 and 38 aluminum wirings. The pMOS transistor, nMOS transistor and bipolar transistor are formed on the same P-type substrate 1.

In the Bi-CMOS with the above construction, a drawback that the withstanding voltage between the emitter 30 and the collector 4 may be lowered occurs when the impurity concentration of the N-type epitaxial layer 4 acting as a collector of the bipolar transistor is high. In order to solve this drawback, it is considered to set the impurity concentration of the N-type epitaxial layer 4 lower than a predetermined impurity concentration.

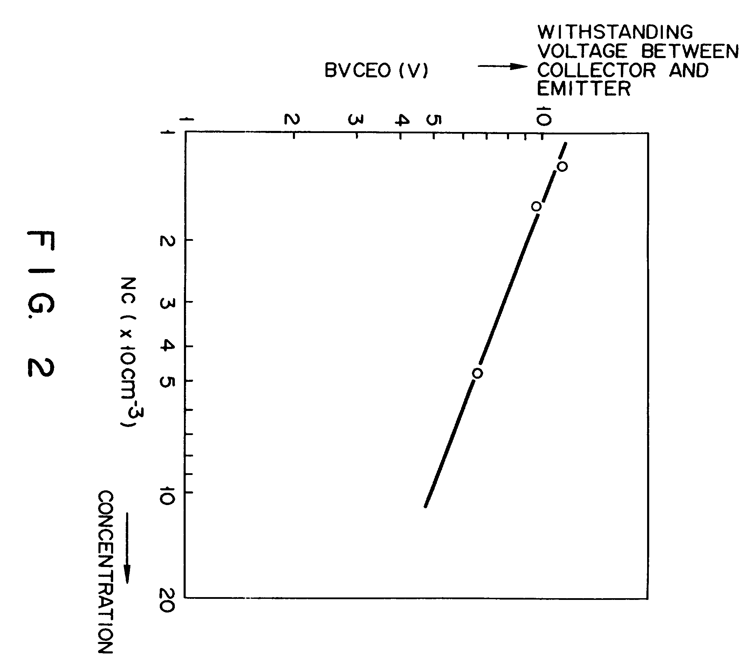

Fig. 2 shows the relation between the impurity concentration of the collector and the collector-emitter withstanding voltage (open base). As shown in Fig. 2, as the impurity concentration Nc of the collector becomes lower, the collector-emitter voltage BV_{CEO} becomes higher.

However, when the impurity concentration of the N-type epitaxial layer 4 of the bipolar transistor is lowered, current flows via a PNP parasitic transistor formed of the P-well region 5, N-type epitaxial layer 4 and base regions 24 and 19, causing a punch-through phenomenon. When the impurity concentration of the N-type epitaxial layer 4 is lowered, the resistance of the N-type epitaxial layer 4 becomes larger, making the collector resistance larger.

GB-A-1 280 022 shows the features of the preamble of claim 1.

EP-A-0 219 641 shows a MOSFET and a bipolar transistor on the same substrate. A buried N well (14) formed over the buried collector area (3) has a uniform impurity concentration.

JP-A-63 240 058 shows implanting boron ions, and lowering the impurity concentration in an N-well used for forming a bipolar transistor.

US-A-4 267 557 shows a protective diode with a uniform impurity concentration collector region under the base region.

An object of this invention is to provide a semiconductor device in which the withstanding voltage preventing the punch-through phenomenon in a parasitic transistor can be set high and the collector resistance thereof can be set low while the emitter-collector withstanding voltage can be held at a desired value, and a method for manufacturing the same.

According to the invention, there is provided a semiconductor device as set out in claim 1.

A method of manufacturing a semiconductor device according to claim 1 is defined in claim 4.

In this invention, the impurity concentration of at least part of the low impurity concentration collector region which lies between the emitter region and the collector region is set low so that a high emitter-collector withstanding voltage can be obtained.
Further, the impurity concentration of at least part of the low impurity concentration collector region which lies between the base region and the opposite conductivity type region is set high so that a withstanding voltage preventing the punch-through phenomenon in the parasitic transistor formed of the base region, collector region and opposite conductivity type region can be enhanced and the collector resistance can be lowered.

This invention can be more fully understood from the following detailed description when taken in conjunction with the accompanying drawings, in which:
Fig. 1 is a cross sectional view showing the construction of the conventional Bi-CMOS device;
Fig. 2 shows the relation between the impurity concentration of the collector and the collector-emitter withstanding voltage in a bipolar transistor of Fig. 1;
Figs. 3A to 3G are cross sectional views for illustrating the process of manufacturing a first embodiment of a semiconductor device of this invention;
Fig. 4 is a cross sectional view showing the construction of an embodiment not covered by the invention; and
Fig. 5 is a cross sectional view, showing the construction of an embodiment not covered by the invention.

There will now be described embodiments of the present invention with reference to the accompanying drawings.

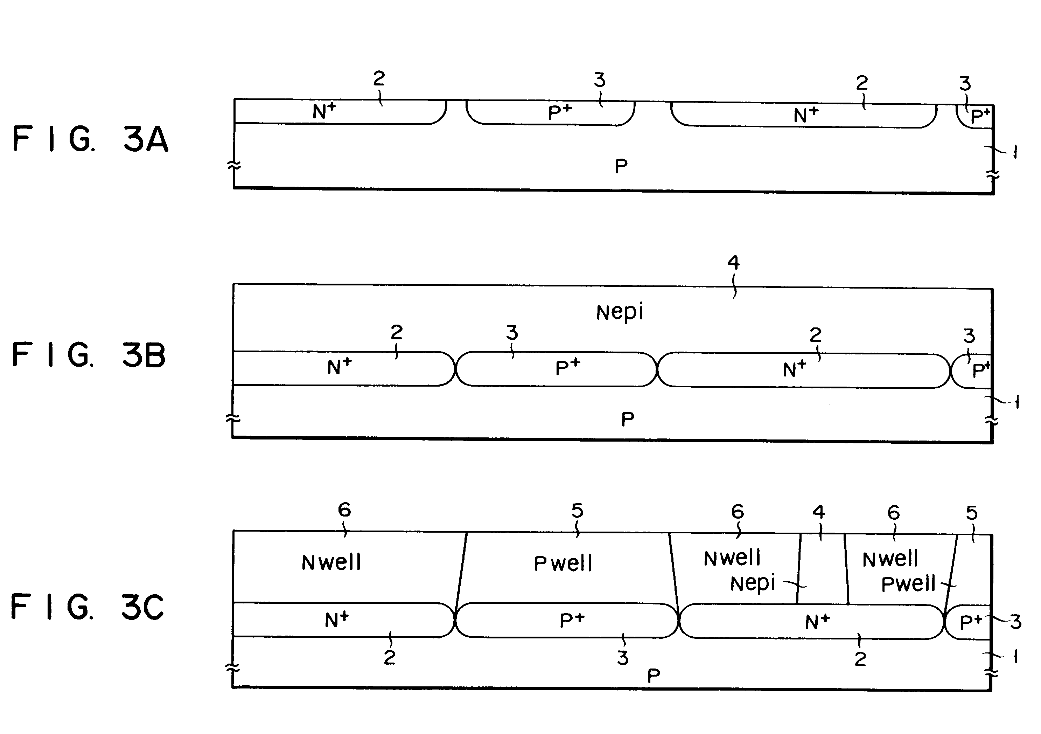

Figs. 3A to 3G are cross sectional views for illustrating the steps of manufacturing a first embodiment of a semiconductor device of this invention. As shown in Fig. 3A, N⁺-buried layers 2 are selectively formed in those portions of the surface area of a P-type semiconductor substrate 1 of monocrystalline silicon on which a bipolar transistor and a pMOS transistor are formed by using the lithographic method and ion-implantation technique. For example, arsenic (As) or antimony (Sb) is used in the ion-implantation process. The N⁺-buried layer 2 is used as a high impurity concentration collector region of the bipolar transistor. Then, boron (B) is ion-implanted into those portions of the surface area of the substrate 1 on which nMOS transistors are formed by using the lithographic method and ion-implantation technique to form P⁺-buried layers 3. The ion-implantation condition for boron (B) is that the acceleration energy is 100 KeV and the dose amount is 1.5 × 10¹³ cm⁻², for example.

After this, as shown in Fig. 3B, an N-type epitaxial layer 4 containing phosphorus (P) of approx. 1 × 10¹⁶ cm⁻³, for example, is formed on the semiconductor substrate 1 by using the epitaxial growth method. At this time, the growth temperature is set at 1130°C and the thickness of the epitaxial layer is approx. 1.2 µm.

Next, as shown in Fig. 3C, a mask (not shown) is formed by using the lithographic method and then boron (B) is ion-implanted into the nMOS forming area of the N-type epitaxial layer 4 with the acceleration energy of 100 KeV and the dose amount of 6 × 10¹² cm⁻², for example, so as to selectively form P-well regions 5. After this, the mask is removed. Then, an ion-implantation mask (not shown) is formed on an area other than the pMOS forming area and emitter forming area by the lithographic method, and phosphorus (P) is then ion-implanted into the N-type epitaxial layer 4 with the acceleration energy of 160 KeV and the dose amount of 5 × 10¹² cm⁻², for example, so as to selectively form N-well regions 6 in the bipolar transistor forming areas.

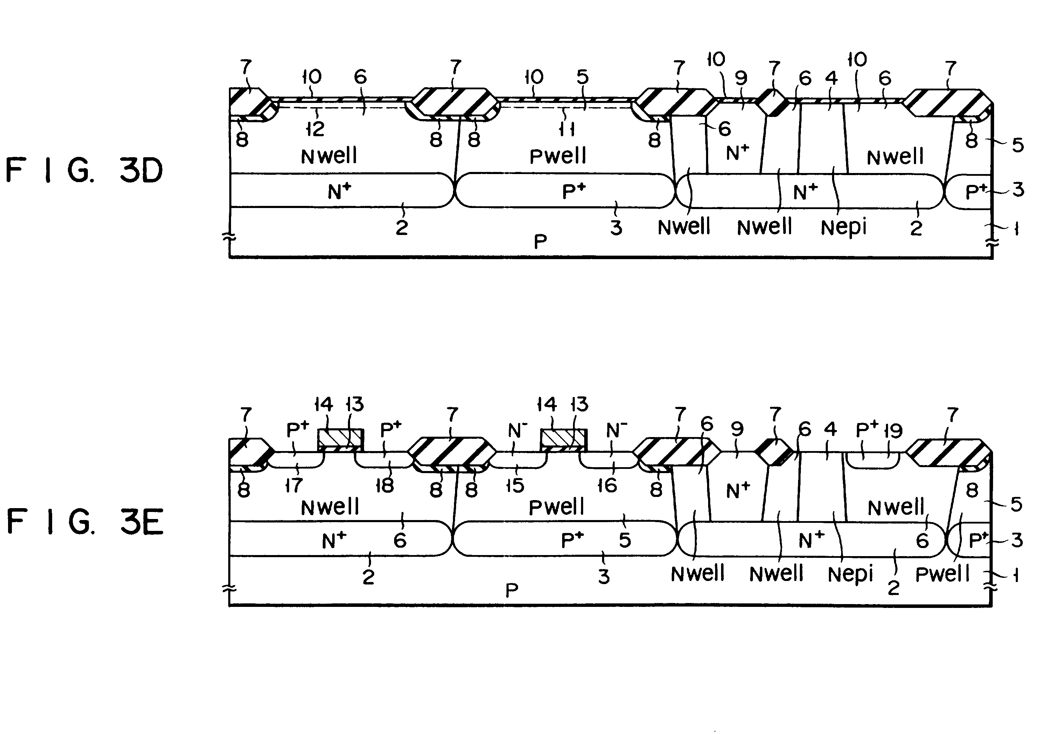

Next, as shown in Fig. 3D, an SiN film (not shown) is formed and a preset ion-implantation mask (not shown) is formed on the SiN film as the preparation process for forming field oxide films 7. In order to form field lu inversion preventing ion-implanted regions 8 in the formation areas of the field oxide films 7 of the MOS transistors, arsenic (As) or antimony (Sb) is ion-implanted into the p-channel MOS transistor area, for example, and boron (B) is ion-implanted into the n-channel MOS transistor area, for example. Next, the field oxide films 7 for isolating the MOS transistors from each other and from the bipolar transistor are formed by the selective oxidation method. After this, a mask is formed on an area other than the formation area of an N⁺-type diffused region 9 in the N-well region 6 and the N⁺-type diffused region 9 is formed in connection with the N⁺-buried layer 2 by using the ion-implantation technique. Arsenic (As) or antimony (Sb) is used in the ion-implantation process, for example.

Next, a dummy gate oxide film 10 is formed to a thickness of approx. 15nm (150 Å) on the entire surface of the resultant structure by a thermal oxidation method. Then, channel ion-implantation regions 11 and 12 are formed in the P-well region 5 and N-well region 6, respectively. The channel ion-implantation regions 11 and 12 are formed to properly match the threshold voltages of the N-channel MOS transistor and P-channel MOS transistor and prevent occurrence of the punch-through phenomenon. The channel ion-implantation region 11 of the N-channel MOS transistor is formed by ion-implanting boron (B) ions with the acceleration energy of 20 KeV and the dose amount of 4 × 10¹² cm⁻², for example. The channel ion-implantation region 12 of the P-channel MOS transistor is formed by effecting two ion-implantation processes including the process of ion-implanting boron (B) ions with the acceleration energy of 20 KeV and the dose amount of 3 × 10¹² cm⁻² and the process of ion-implanting phosphorus (P) ions with the acceleration energy of 240 KeV and the dose amount of 2 × 10¹² cm⁻².

Next, as shown in Fig. 3E, the dummy gate oxide film 10 is completely removed from the entire surface and then a gate oxide film is formed to a thickness of approx. 15nm (150 Å) on the entire surface by using the thermal oxidation method. In order to form gate electrodes 14, a polysilicon layer is deposited to a predetermined thickness on the gate oxide film by the chemical vapor deposition (CVD) method. Then, impurity is doped into the polysilicon layer by a phosphorus (P) diffusing method to lower the resistance of the polysilicon layer. The gate oxide film and the polysilicon layer are patterned by using the lithographic process so as to form gate insulation films 13 and the gate electrodes 14 of the MOS transistors on the P-well region 5 and N-well region 6. After a mask is formed on an area other than the P-well region 5, and then phosphorus (P) ions are ion-implanted into the P-well region 5 to form an N⁻-type source region 15 and drain region 16. At this time, the field oxide film 7 and gate electrodes 14 are served as masks. The ion-implantation process is effected with the acceleration energy of, for example, 60 KeV and the dose amount of 4 × 10¹³ cm⁻², for example. Likewise, a mask is formed on an area other than the N-well region 6 and then BF₂ ions are ion-implanted into the N-well region 6 to form a P⁺-type source region 17 and drain region 18. The ion-implantation process is effected with the acceleration energy of, for example, 50 KeV and the dose amount of 5 × 10¹⁵ cm⁻², for example. By the ion-implantation of BF₂ ions, an external base region 19 in the formation area of the bipolar transistor is also formed.

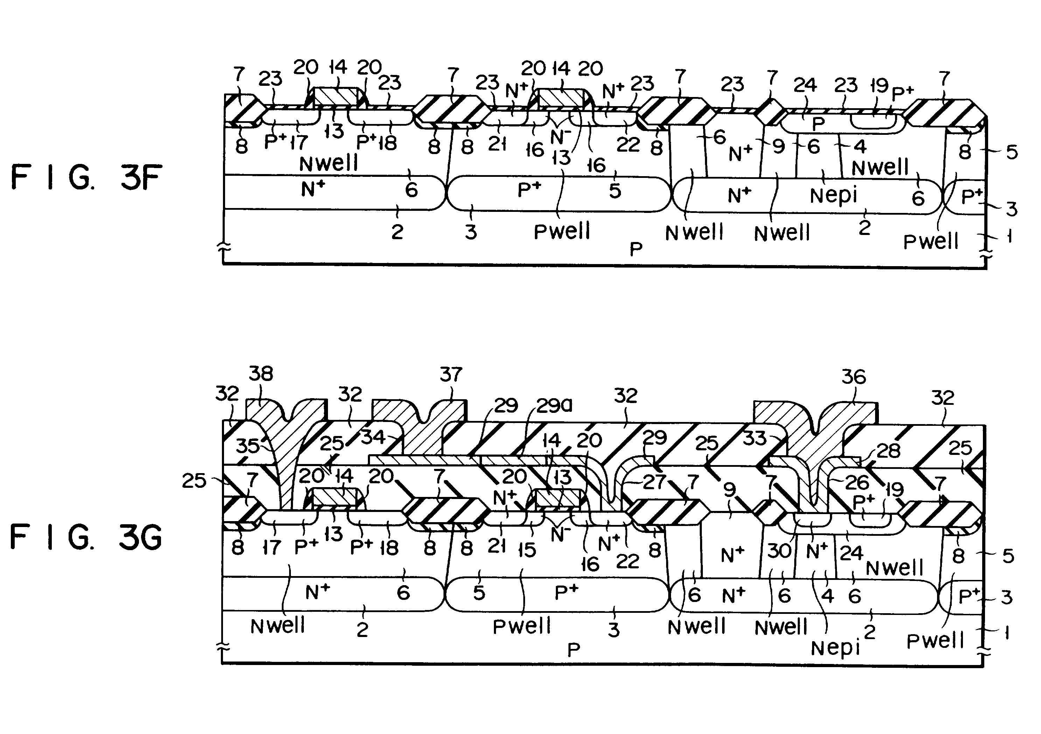

Next, as shown in Fig. 3F, a CVD-SiO₂ film (not shown) is deposited to a thickness of 200 nm (2000 Å) on the entire surface by the CVD method and then the CVD-SiO₂ film is etched by an anisotropic etching method such as a reactive ion etching (RIE) method to leave SiO₂ films 20 only on the side portions of the gate electrodes 14. After this, a mask is formed on an area other than the P-well region 5 and then As ions are ion-implanted into the surface area with the acceleration energy of 50 KeV and the dose amount of 5 × 10¹⁵ cm⁻² so as to form an N⁺-type source region 21 and N⁺-type drain region 22 in the P well region 5. As a result, an N-channel MOS transistor of so-called lightly doped drain (LDD) structure is formed. Then, an oxidation process is effected at a temperature of 900°C in an O₂ atmosphere for 30 minutes to form an oxide film 23 on the entire surface. A mask is formed by the lithographic method and then a P-type base region 24 of the bipolar transistor is formed. The base region 24 is formed by ion-implanting BF₂ ions with the acceleration energy of, for example, 30 KeV and the dose amount of 5 × 10¹³ cm⁻², for example. After this, the mask is removed.

Next, as shown in Fig. 3G, a CVD-SiO₂ film 25 is deposited to a thickness of 200 nm (2000 Å) on the entire surface by the CVD method. Then, a contact hole 26 which reaches the surface of the base region 24 is formed in the CVD-SiO₂ film 25 by the RIE method, and a contact hole 27 which reaches the surface of the N⁺-type drain region 22 of the N-channel MOS transistor is also formed in the CVD-SiO₂ film 25. After this, a polysilicon layer is deposited to a thickness of 200 nm (2000 Å) on the entire surface. Then, it is patterned by using the lithographic method and RIE method so as to leave polysilicon layers 28, 29 and 31. Next, a mask (not shown) such as a photoresist is formed to cover part of the polysilicon layer 29, and As ions are ion-implanted into the polysilicon layers 28 and 29 with the acceleration energy of 50 KeV and the dose amount of 5 × 10¹⁵ cm⁻². Then, the mask is removed. By the ion-implantation process, an N-type emitter region 30 is formed in part of the base region 24, and at the same time, the electrical resistance of the polysilicon layer 28 is lowered to form the emitter electrode of the bipolar transistor. Further, the resistance of a portion of the polysilicon layer 29 other than a polysilicon layer 29a is lowered by the above ion-implantation process to form a drain wiring of the N-channel MOS transistor. That portion of the polysilicon layer whose resistance is not lowered is used as the high-resistance element 29a. The two N-well regions 6 formed in contact with the P-type base region 24 and the N-type epitaxial layer 4 constitute a low impurity concentration collector region.

Next, an interlayer film 32 formed of a CVD-SiO₂ film and a BPSG (silicon glass containing B and P) film which is an insulation film is deposited on the entire surface to make the surface flat. A contact hole 33 which reaches the polysilicon layer 28 serving as the emitter electrode and a contact hole 34 which reaches the polysilicon layer 29 serving as the drain wiring is formed in the interlayer film 32 by using the RIE method. Further, a contact hole 35 which reaches the source region 17 of the P-channel MOS transistor is formed in the interlayer film 32 and CVD-SiO₂ film 25. Then, aluminum for wirings is deposited on the entire surface by a vapor deposition method or the like and it is patterned by the photolithographic method and RIE method to form aluminum wirings 36, 37 and 38. In this way, the semiconductor device of the first embodiment of this invention is completed.

According to the first embodiment, since the N-well region 6 having a relatively high impurity concentration is formed in the low impurity concentration collector region between the base region 24 and the P-well region 5, occurrence of the punch-through phenomenon in the bipolar transistor formed of the base region 24, N-well region 6 serving as the relatively high impurity concentration collector region and the P-well region 5 can be prevented. Further, since the impurity concentration of the N-type epitaxial layer (collector region) 4 formed below the emitter region 30 is lower than that of the N-well region 6, the emitter-collector withstanding voltage can be kept at a proper value. In addition, since the N-well region 6 having an impurity concentration higher than that of the N-type epitaxial layer 4 is formed between the base region 24 and the N⁺-type diffused layer 9, the collector resistance can be reduced.

Further, in the above method of manufacturing the semiconductor device, the step of forming the N-well region 6 of the pMOS transistor and the step of forming the N-well region 6 in the N-type epitaxial layer 4 of the bipolar transistor can be effected at the same time. Therefore, the number of steps is not increased in comparison with the conventional manufacturing method.

Further, in the first embodiment, the P-type base region 24 is formed in contact with the collector of the npn junction transistor, but the same effect can be attained in a case where an N-type base region is formed in contact with the collector of a pnp junction transistor.

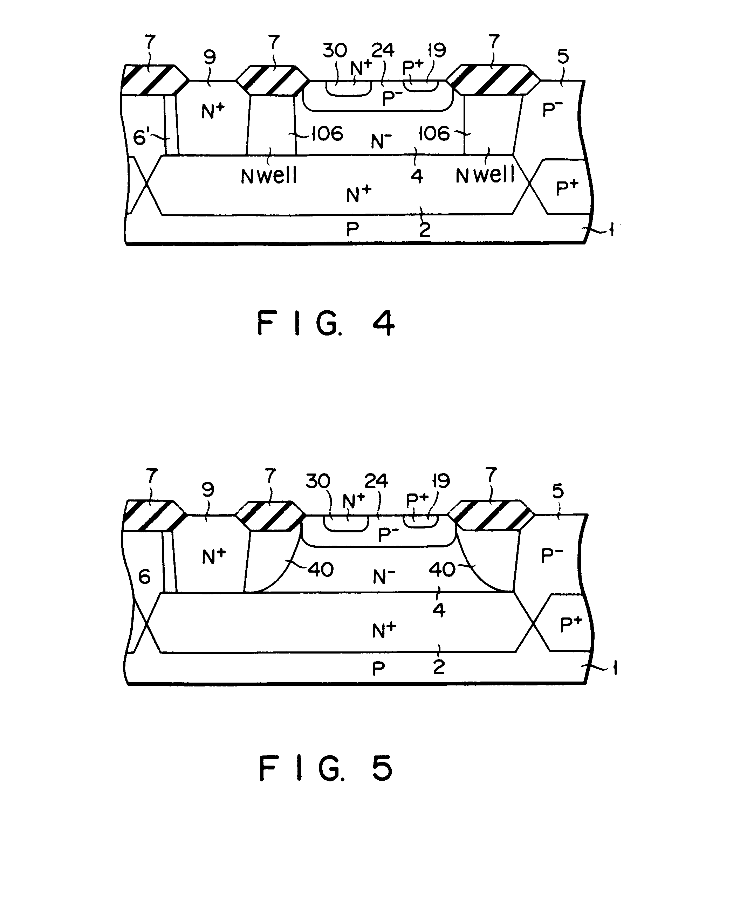

Fig. 4 is a cross sectional view showing an embodiment not covered by the invention. In Fig. 4, portions which are the same as those in the first embodiment are denoted by the same reference numerals and the explanation thereof is omitted. As shown in Fig. 4, in the embodiment, an N-well region 106 of high impurity concentration which is a collector of the bipolar transistor is formed so as not to be in contact with a base region 24. That is, all the portion lying under the P-type base region 24 of the bipolar transistor is formed of an N-type epitaxial layer 4 of low impurity concentration, and the N-well region is formed separately from the base region 24.

With this embodiment, the junction capacitance of the N-type epitaxial layer 4 serving as the collector can be reduced in comparison with the case of the first embodiment, and, at the same time, occurrence of the punch-through phenomenon of a parasitic transistor can be prevented and the collector resistance can be reduced as in the first embodiment.

Fig. 5 is a cross sectional view showing the construction of an embodiment not covered by the invention. In this embodiment, a field N⁻-region 40 is formed in the surface area of an N-type epitaxial layer 4 of the bipolar transistor. The method of forming the semiconductor device of this embodiment is explained with reference to Figs. 3 and 5. In this embodiment, after the steps of Figs. 3A and 3B are effected, a step of Fig. 3C in which an N-well region 6 is formed in a bipolar transistor forming area is not effected. When a step of Fig. 3D in which a field inversion preventing ion-implanted region 8 is formed in a P-channel MOS transistor area by the ion-implantation technique is effected, ions are simultaneously implanted in those portions of the N-type epitaxial layer 4 other than the base forming area 24 of the bipolar transistor forming area, N⁺-diffused layer 9 and P-well region 5, thus forming the field N⁻-region 40. After this, the mask is removed and then the same steps as those of the first embodiment are effected.

With this embodiment, the junction capacitance of the collector can also be reduced. Further, the withstanding voltage against the punch-through of the parasitic transistor can be raised and the collector resistance can be reduced.

Reference signs in the claims are intended for better understanding and shall not limit the scope.

## Claims

1. A semiconductor device comprising:
a semiconductor substrate (1);
an emitter region (30) of a first conductivity type formed on said semiconductor substrate (1);
a base region (24) of a second conductivity type formed to surround said emitter region (30);
a low impurity concentration collector region (4, 6) of the first conductivity type formed to surround said base region (24);
a high impurity concentration collector region (2) of the first conductivity type formed under said low impurity concentration collector region (4, 6); and
a well region (5) of the second conductivity type formed in contact with and being laterally adjacent to said low impurity concentration collector region (4, 6);
wherein a first part (4) of said low impurity concentration collector region (4, 6) which lies between said base region (24) and said high impurity concentration collector region (2) and directly below said emitter region (30) is formed to have an impurity concentration lower than that of a second part (6) of said low impurity concentration collector region (4, 6) which lies between said base region (24) and said high impurity concentration collector region (2) and between said base region (24) and said well region (5) of the second conductivity type, characterized in that the second part extends beneath and is in contact with the bottom of the base region (24) and extends from the first part to the well region (5).

2. A semiconductor device according to claim 1, characterized by further comprising a first conductivity type region (6) formed on said semiconductor substrate (1);
source (17) and drain (18) regions of the second conductivity type separately formed on said first conductivity type region; and
an electrode (13) formed on said first conductivity type region (6) which lies between said source (17) and drain (18) regions.

3. A semiconductor device according to claim 1, characterized in that the impurity concentration of said first part (4) of said low impurity concentration collector region (4, 6) which lies directly below said emitter region (30) is lower than that of a portion (6) of said low impurity concentration collector region (4, 6) which does not lie directly below said emitter region (30).

4. A Method of manufacturing a semiconductor device according to claim 1, comprising the steps of:
forming at least two first buried layers (2) having a high impurity concentration on selected surfaces in a second MOS transistor-forming region and a bipolar transistor-forming region of a semiconductor substrate (1), respectively, and forming a second buried layer (3) having a high impurity concentration in a first MOS transistor-forming region of said semiconductor substrate (1);
forming an epitaxial layer (4) of a first conductivity type on the entire surfaces of said semiconductor substrate (1);
forming a well region (5) of a second conductivity type in said first MOS transistor-forming region, said well region (5) having an impurity concentration higher than that of said epitaxial layer (4);
forming at least two ion-injected regions (8, 8) of said first conductivity type in a first portion of said epitaxial layer (4) which is located above said second MOS transistor-forming region and a second portion of said epitaxial layer (4) which is located above said bipolar transistor-forming region and excluding a portion located below a base-forming portion, respectively, said ion-injected regions preventing a field region from being inverted;
forming device-isolation insulating film (7) on selected surfaces of the resultant structure;
forming a first MOS transistor in said well region (5) of the second conductivity type formed in said first MOS transistor-forming region, and a second MOS transistor in a well region (6) of the first conductivity type formed in said second MOS transistor-forming region; and
forming a bipolar transistor in said epitaxial layer (4) and a well region (6) of the first conductivity type formed in said bipolar transistor-forming region.

5. A method according to claim 4, characterized in that said step of forming the well region (6) of the first conductivity type in that portion of said epitaxial layer (4) which is located above said bipolar transistor-forming region and other than that portion located below an emitter-forming portion is to form the well region (6) of the first conductivity type, in contact with a base region (24) of the bipolar transistor-forming region.

6. A method according to claim 4, characterized by further comprising the step of forming ion-injected regions (8) for preventing field inversion, in those portions of said first and second MOS transistor-forming regions in which said device-isolation insulating films (7) is to be formed.

## Patentansprüche

1. Halbleitereinrichtung, enthaltend:
ein Halbleitersubstrat (1);
ein Emittergebiet (30) eines ersten Leitungstyps, gebildet auf dem Halbleitersubstrat (1);
ein Basisgebiet (24) eines zweiten Leitungstyps, gebildet im Umfeld des Emittergebiets (30);
ein Kollektorgebiet mit niedriger Verunreinigungskonzentration (4, 6) des ersten Leitungsgebiets, gebildet im Umfeld des Basisgebiets (24);
ein Kollektorgebiet mit hoher Verunreinigungskonzentration (2) des ersten Leitungstyps, gebildet unter dem Kollektorgebiet mit niedriger Verunreinigungskonzentration (4, 6); und
ein Wannengebiet (5) des zweiten Leitungstyps, gebildet in Kontakt und seitlich benachbart zu dem Kollektorgebiet mit geringer Verunreinigungskonzentration (4, 6); derart, daß
ein erster Teil (4) des Kollektorgebiets mit niedriger Verunreinigungskonzentration (4, 6), der zwischen dem Basisgebiet (24) und dem Kollektorgebiet (2) mit hoher Verunreinigungskonzentration liegt und direkt unterhalb dem Emittergebiet (30), so ausgebildet ist, daß er eine Verunreinigungskonzentration aufweist, die niedriger ist als diejenige eines zweiten Teils (6) des Kollektorgebiets mit geringer Verunreinigungskonzentration (4, 6), der zwischen dem Basisgebiet (24) und dem Kollektorgebiet mit hoher Verunreinigungskonzentration (2) liegt und zwischen dem Basisgebiet (24) und dem Wannengebiet (5) des zweiten Leitungstyps,
**dadurch gekennzeichnet, daß**
der zweite Teil sich unterhalb der Unterseite des Basisgebiets (24) erstreckt und in Kontakt hierzu vorliegt und er sich von dem ersten Teil zu dem Wannengebiet (5) erstreckt.

2. Halbleitereinrichtung nach Anspruch 1, dadurch gekennzeichnet, daß er ferner ein Gebiet (6) eines ersten Leitungstyps aufweist, das auf dem Halbleitereinrichtung gebildt ist (1); sowie
Source- (17) und Drain- (18)-Gebiete des zweiten Leitungstyps, die getrennt auf dem Gebiet des ersten Leitungstyps gebildet sind; und
eine Elektrode (13), die auf dem Gebiet (6) des ersten Leitungstyps gebildet ist und die zwischen dem Source-(17) und dem Drain- (18)-Gebiet liegt.

3. Halbleitereinrichtung nach Anspruch 1, dadurch gekennzeichnet, daß die Verunreinigungskonzentration des ersten Teils (4) des Kollektorgebiets (4, 6) mit geringer Verunreinigungskonzentration, der direkt unterhalb dem Emittergebiet (30) liegt, niedriger ist als derjenige eines Abschnitts (6) des Kollektorgebiets (4, 6) mit geringer Verunreinigungskonzentration, der nicht direkt unterhalb dem Emittergebiet (30) liegt.

4. Verfahren zum Herstellen einer Halbleitereinrichtung nach Anspruch 1, enthaltend die Schritte:
Bilden von zumindest zwei vergrabenen Schichten (2) mit einer hohen Verunreinigungskonzentration jeweils auf ausgewählten Teilflächen in einem zweiten MOS-Transistor-Ausbildungsgebiet und einem Bipolartransistor-Ausbildungsgebiet eines Halbleitersubstrats (1) und Bilden einer zweiten vergrabenen Schicht (3) mit hoher Verunreinigungskonzentration in einem ersten MOS-Transistor-Ausbildungsgebiet des Halbleitersubstrats (1);
Bilden einer Epitaxialschicht (4) eines ersten Leitungstyps auf der Gesamtfläche des Halbleitersubstrats (1);
Bilden eines Wannengebiets (5) eines zweiten Leitungstyps in dem ersten MOS-Transistor-Ausbildungsgebiet, derart, daß das Wannengebiet (5) eine Verunreinigungskonzentration aufweist, die höher ist als diejenige der Epitaxialschicht (4);
Bilden von zumindest zwei ioneninjizierten Gebieten (8, 8) des ersten Leitungstyps jeweils in einem ersten Abschnitt der Epitaxialschicht (4), der oberhalb des zweiten MOS-Transistor-Ausbildungsgebiets angeordnet ist, sowie eines zweiten Abschnitts der Epitaxialschicht (4), der oberhalb des Bipolartransistor-Ausbildungsgebiets angeordnet ist und einen Abschnitt ausschließt, der unterhalb eines BasisAusbildungsgebiets angeordnet ist, derart, daß die ioneninjizierten Gebiete die Invertierung eines Feldgebiets vermeiden;
Bilden eines Einrichtungsisolations-Isolierfilms (7) auf ausgewählten Teilflächen der sich ergebenden Struktur;
Bilden eines ersten MOS-Transistors in dem Wannengebiet (5) des zweiten Leitungstyps, gebildet in dem ersten MOS-Transistor-Ausbildungsgebiet, und eines zweiten MOS-Transistors in einem Wannengebiet (6) des ersten Leitungstyps, gebildet in dem zweiten MOS-Transistor-Ausbildungsgebiet; und
Bilden eines Bipolartransistors in der Epitaxialschicht (4) und eines Wannengebiets (6) des ersten Leitungstyps, gebildet in dem Bipolar-Transistor-Ausbildungsgebiet.

5. Verfahren nach Anspruch 4, dadurch gekennzeichnet, daß der Schritt zum Bilden des Wannengebiets (6) des ersten Leitungstyps in dem Abschnitt der Epitaxialschicht (4), die oberhalb des Bipolartransistor-Ausbildungsgebiets angeordnet ist und sich von demjenigen Abschnitt unterscheidet, der unterhalb eines EmitterAusbildungsgebiets angeordnet ist, der Bildung des Wannengebiets (6) des ersten Leitungstyps in Kontakt mit einem Basisgebiet (24) des Bipolartransistor-Ausbildungsgebiets dient.

6. Verfahren nach Anspruch 4, dadurch gekennzeichnet, daß ferner der Schritt zum Bilden von ioneninitiierten Gebieten (8) zum Vermeiden der Feldinversion vorgesehen ist, und zwar in denjenigen Gebieten des ersten und zweiten MOS-Transistor-Ausbildungsgebiets, in dem die Einrichtungsisolations-Isolierfilme (7) zu bilden sind.

## Revendications

1. Dispositif à semiconducteur comprenant :
un substrat semiconducteur (1);
une région d'émetteur (30) d'un premier type de conductivité formée sur ledit substrat semiconducteur (1);
une région de base (24) d'un second type de conductivité formée de manière à entourer ladite région d'émetteur (30) ;
une région de collecteur à concentration en impuretés faible (4, 6) du premier type de conductivité formée de manière à entourer ladite région de base (24) ;
une région de collecteur à concentration en impuretés élevée (2) du premier type de conductivité formée sous ladite région de collecteur à concentration en impuretés faible (4, 6) ; et
une région de puits (5) du second type de conductivité formée en contact avec ladite région de collecteur à concentration en impuretés faible (4, 6) et adjacente latéralement à celle-ci,
où une première partie (4) de ladite région de collecteur à concentration en impuretés faible (4, 6) qui est située entre ladite région de base (24) et ladite région de collecteur à concentration en impuretés élevée (2) et directement au-dessous de ladite région d'émetteur (30) est formée de manière à présenter une concentration en impuretés inférieure à celle d'une seconde partie (6) de ladite région de collecteur à concentration en impuretés faible (4, 6) qui est située entre ladite région de base (24) et ladite région de collecteur à concentration en impuretés élevée (2) et entre ladite région de base (24) et ladite région de puits (5) du second type de conductivité,
caractérisé en ce que la seconde partie s'étend au-dessous du fond de la région de base (24) et est en contact avec et s'étend depuis la première partie jusqu'à la région de puits (5).

2. Dispositif à semiconducteur selon la revendication 1, caractérisé en ce qu'il comprend en outre :
une région du premier type de conductivité (6) formée sur ledit substrat semiconducteur (1);
des régions de source (17) et de drain (18) du second type de conductivité formées séparément sur ladite région du premier type de conductivité ; et
une électrode (13) formée sur ladite région du premier type de conductivité (6) qui est située entre lesdites régions de source (17) et de drain (18).

3. Dispositif à semiconducteur selon la revendication 1, caractérisé en ce que la concentration en impuretés de ladite première partie (4) de ladite région de collecteur à concentration en impuretés faible (4, 6) qui est située directement au-dessous de ladite région d'émetteur (30) est inférieure à celle d'une partie (6) de ladite région de collecteur à concentration en impuretés faible (4, 6) qui n'est pas située directement au-dessous de ladite région d'émetteur (30).

4. Procédé de fabrication d'un dispositif à semiconducteur selon la revendication 1, comprenant les étapes de :
formation d'au moins deux premières couches enterrées (2) présentant une concentration en impuretés élevée sur des surfaces sélectionnées respectivement dans une seconde région de formation de transistor MOS et dans une région de formation de transistor bipolaire d'un substrat semiconducteur (1) et formation d'une seconde couche enterrée (3) présentant une concentration en impuretés élevée dans une première région de formation de transistor MOS dudit substrat semiconducteur (1);
formation d'une couche épitaxiale (4) d'un premier type de conductivité sur la totalité des surfaces dudit substrat semiconducteur (1);
formation d'une région de puits (5) d'un second type de conductivité dans ladite première région de formation de transistor MOS, ladite région de puits (5) présentant une concentration en impuretés supérieure à celle de ladite couche épitaxiale (4);
formation d'au moins deux régions à ions injectés (8, 8) dudit premier type de conductivité respectivement dans une première partie de ladite couche épitaxiale (4) qui est située au-dessus de ladite seconde région de formation de transistor MOS et dans une seconde partie de ladite couche épitaxiale (4) qui est située au-dessus de ladite région de formation de transistor bipolaire et en excluant une partie située au-dessous d'une partie de formation de base, lesdites régions à ions injectés empêchant l'inversion d'une région de champ ;
formation d'un film isolant d'isolation de dispositif (7) sur des surfaces sélectionnées de la structure résultante ;
formation d'un premier transistor MOS dans ladite région de puits (5) du second type de conductivité formée dans ladite première région de formation de transistor MOS et d'un second transistor MOS dans une région de puits (6) du premier type de conductivité formée dans ladite seconde région de formation de transistor MOS ; et
formation d'un transistor bipolaire dans ladite couche épitaxiale (4) et dans une région de puits (6) du premier type de conductivité formée dans ladite région de formation de transistor bipolaire.

5. Procédé de fabrication d'un dispositif à semiconducteur selon la revendication 4, caractérisé en ce que ladite étape de formation de la région de puits (6) du premier type de conductivité dans la partie de ladite couche épitaxiale (4) qui est située au-dessus de ladite région de formation de transistor bipolaire et qui est autre que la partie située au-dessous d'une partie de formation d'émetteur a pour but de former la région de puits (6) du premier type de conductivité en contact avec une région de base (24) de la région de formation de transistor bipolaire.

6. Procédé de fabrication d'un dispositif à semiconducteur selon la revendication 4, caractérisé en ce qu'il comprend en outre l'étape de formation de régions à ions injectés (8) pour empêcher une inversion de champ dans les parties desdites première et seconde régions de formation de transistor MOS dans lesquelles lesdits films isolants d'isolation de dispositif (7) doivent être formés.
